# EUROPEAN PATENT APPLICATION

(11) **EP 2 275 588 A1**
(43) Date of publication of application: **19.01.2011**
(21) Application number: 10167321.8
(22) Date of filing: 25.06.2010
(51) Int. Cl.: C23C 14/54

(54) **Vacuum vapor deposition apparatus**

(30) Priority: 13.07.2009 JP 2009164424
(71) Applicant: MITSUBISHI HEAVY INDUSTRIES, LTD., Tokyo (JP)
(72) Inventor: Hirano, Tatsuya, Minato-ku Tokyo (JP); Yanagi, Yuji, Minato-ku Tokyo (JP); Shigeoka, Nobuyuki, Minato-ku Tokyo (JP)
(74) Representative: HOFFMANN EITLE

(57) **Abstract**

Provided is a vacuum vapor deposition apparatus in which a crucible (3) as a container for vaporizing a vapor deposition material (2) is placed inside a vacuum chamber (1) and a film is formed on a substrate (4) by use of the vapor deposition material (2) vaporized in the crucible (3). The apparatus includes measuring means for measuring a bulk of the vapor deposition material (2) in the crucible (3) from an outside of the vacuum chamber (1).

## Description

### {Technical Field}

The present invention relates to a vacuum vapor deposition apparatus.

### {Background Art}

There has heretofore been known a vacuum vapor deposition apparatus in which a crucible as a container for vaporizing a vapor deposition material is placed inside a vacuum chamber and a film is formed on a substrate by use of the vapor deposition material vaporized in the crucible. For a vacuum vapor deposition apparatus of this kind, knowing the quantity of the vapor deposition material remaining in the crucible is necessary for figuring out the timing to refill an additional vapor deposition material into the crucible. Knowing the quantity of the vapor deposition material remaining in the crucible also helps prevent the crucible from breaking due to a difference in shrinkage between the crucible and the vapor deposition material generated when they are cooled.

In this respect, the quantity of the remaining vapor deposition material has conventionally been estimated on the basis of a rate and a time period for film formation in the general practice. However, there is in fact a large amount of wasted vapor not contributing to the film formation on the substrate, such as vapor adhering to a wall surface of the vacuum chamber and the like. For this reason, tests need to be carried out in advance to obtain data necessary for the estimation of the quantity of the remaining vapor deposition material, which involve quite complicated works.

To solve this, for example, Patent Literature 1 below has disclosed a vacuum vapor deposition apparatus in which the quantity of a vapor deposition material remaining in a crucible is measured by measuring changes in mass of the crucible by use of a mass measuring unit attached to the crucible.

### {Citation List}

### {Patent Literature}

{Patent Literature 1} Japanese Patent Application Publication No. 2002-235167

### {Summary of Invention}

### {Technical Problem}

However, the vacuum vapor deposition apparatus disclosed in Patent Literature 1 has the following problem when a vapor deposition material to be used is likely to wet and adhere to a wall surface of a crucible, like aluminum. In this case, it is impossible to distinguish between the quantity of the remaining vapor deposition material substantially usable for the film formation and the quantity of the vapor deposition material which has adhered to the wall surface of the crucible and thus cannot be used for the film formation. Consequently, the quantity of the remaining vapor deposition material substantially usable for the film formation happens to be measured as being larger than the actual one.

In view of the above circumstance, the present invention has an object to provide a vacuum vapor deposition apparatus capable of accurately measuring the quantity of a remaining vapor deposition material substantially usable for film formation.

### {Solution to Problem}

A first aspect of the present invention solving the aforementioned problem provides a vacuum vapor deposition apparatus in which a crucible as a container for vaporizing a vapor deposition material is placed in a vacuum chamber and a film is formed on a substrate by use of the vapor deposition material vaporized in the crucible, the vacuum vapor deposition apparatus characterized by comprising measuring means for measuring a bulk of the vapor deposition material in the crucible from an outside of the vacuum chamber.

A second aspect of the present invention solving the aforementioned problem provides the vacuum vapor deposition apparatus according to the first aspect, **characterized in that** the measuring means measures the bulk of the vapor deposition material in the crucible by use of laser light.

A third aspect of the present invention solving the aforementioned problem provides the vacuum vapor deposition apparatus according to the second aspect, **characterized in that** the measuring means is placed over the crucible.

A fourth aspect of the present invention solving the aforementioned problem provides the vacuum vapor deposition apparatus according to the second aspect, characterized by further comprising one or more mirrors inside the vacuum chamber to reflect the laser light, the vacuum vapor deposition apparatus **characterized in that** the measuring means is placed at a position other than a position over the crucible.

A fifth aspect of the present invention solving the aforementioned problem provides the vacuum vapor deposition apparatus according to the first aspect, **characterized in that** the measuring means measures the bulk of the vapor deposition material in the crucible by use of an X ray.

### {Advantageous Effect of Invention}

With the present invention, it is possible to provide a vacuum vapor deposition apparatus capable of accurately measuring the quantity of a remaining vapor deposition material substantially usable for film formation.

### {Brief Description of Drawings}

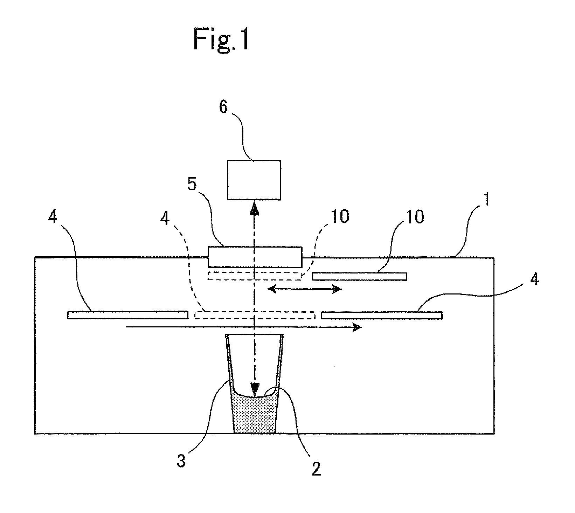

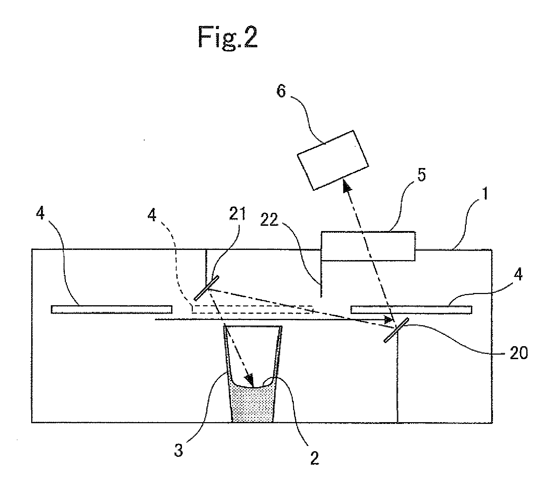

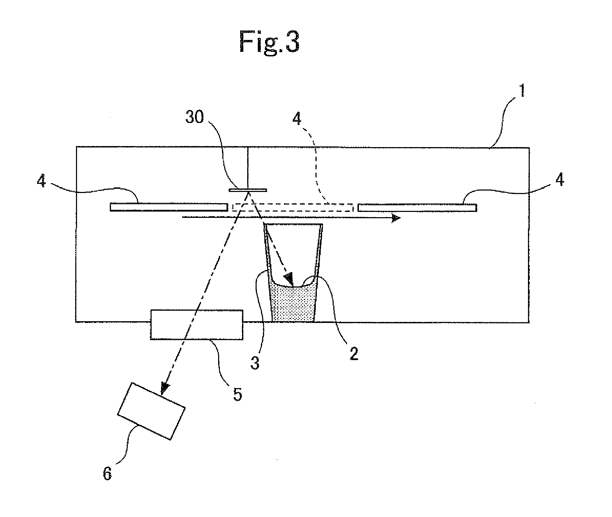

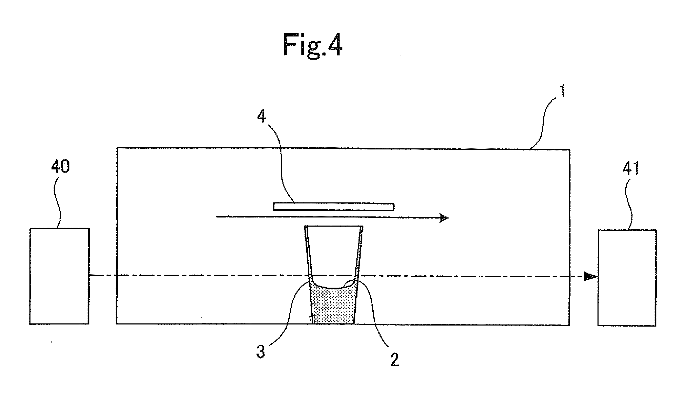

{Fig. 1}Fig. 1 is a schematic view showing the configuration of a vacuum vapor deposition apparatus according to a first example of the present invention.
{Fig. 2}Fig. 2 is a schematic view showing the configuration of a vacuum vapor deposition apparatus according to a second example of the present invention.
{Fig. 3)Fig. 3 is a schematic view showing the configuration of a vacuum vapor deposition apparatus according to a third example of the present invention.
{Fig. 4}Fig. 4 is a schematic view showing the configuration of a vacuum vapor deposition apparatus according to a fourth example of the present invention.

### {Description of Embodiments}

Hereinbelow, embodiments of a vacuum vapor deposition apparatus according to the present invention will be described with reference to the drawings.

### {First Example}

A first example of the vacuum vapor deposition apparatus according to the present invention will be described below.
As shown in Fig. 1, the vacuum vapor deposition apparatus according to the first example has a crucible 3 placed inside a vacuum chamber 1. The crucible 3 is a container for vaporizing a vapor deposition material 2, meaning that the vapor deposition material 2 is vaporized in the crucible 3. As an example, aluminum is used for the vapor deposition material 2 in the first example.

A substrate 4 is placed inside the vacuum chamber 1. The substrate 4 is caused to pass above the crucible 3 so as to form thereon a film with the vaporized vapor deposition material 2. Here, Fig. 1 illustrates an example of how the substrate 4 moves during the film formation; solid lines indicate positions of the substrate 4 when the bulk of the vapor deposition material 2 is measured, and a dotted line indicates a position of the substrate 4 when it is caused to pass above the crucible 3 during the film formation.

A sight glass 5 is provided to the vacuum chamber 1 at a position over the crucible 3. Meanwhile, as an example, quartz glass is used for the sight glass 5 in the first example, but other materials than quartz glass may be used as long as they can transmit laser light therethrough. Below the sight glass 5 inside the vacuum chamber 1, there is placed a shutter 10 to prevent the vapor deposition material 2 from adhering to the sight glass 5 at the time of the film formation. In Fig. 1, as an example, a solid line indicates a position of the shutter 10 at the time of measuring the bulk of the vapor deposition material 2, and a dotted line indicates a position of the shutter 10 during the film formation.

A laser displacement meter 6 is placed above the sight glass 5 outside the vacuum chamber 1. The laser displacement meter 6 measures the distance from the laser displacement meter 6 to the vapor deposition material 2 by irradiating, with laser light, an area around the center of the surface of the vapor deposition material 2 inside the crucible 3 and detecting the laser light reflected by the surface of the vapor deposition material 2. Based on the measured distance, the laser displacement meter 6 measures the bulk of the vapor deposition material 2. Note that at the time of measuring the bulk of the vapor deposition material 2 using the laser displacement meter 6, the temperature of the crucible 3 is lowered down to such a temperature that the vapor deposition material 2 would not be vaporized, in order to prevent the vapor deposition material 2 from adhering to the sight glass 5. Then, based on the measured bulk of the vapor deposition material 2, the laser displacement meter 6 calculates the quantity of the remaining vapor deposition material 2 substantially usable for the film formation. In Fig. 1, as an example, a dashed line indicates the optical path of the laser light.

As described above, according to the vacuum vapor deposition apparatus of the first example, the bulk of the vapor deposition material 2 is measured directly with laser light. This makes it possible to accurately measure the quantity of the remaining vapor deposition material 2 substantially usable for the film formation.

In addition, according to the vacuum vapor deposition apparatus of the first example, the quantity of the remaining vapor deposition material 2, which is collected at the bottom of the crucible 3 and which is substantially usable for the film formation, can be figured out accurately. This makes it possible to avoid the crucible 3 breaking due to a difference in shrinkage between the crucible 3 and the vapor deposition material 2 generated when they are cooled. This accurate detection is especially effective for, for example, a PBN (pyrolitic boron nitride) crucible 3 which is fragile because of its thin sidewall.

### {Second Example}

A second example of the vacuum vapor deposition apparatus according to the present invention will be described below.
As shown in Fig. 2, the vacuum vapor deposition apparatus according to the second example has a crucible 3 placed inside a vacuum chamber 1. The crucible 3 is a container for vaporizing a vapor deposition material 2, meaning that the vapor deposition material 2 is vaporized in the crucible 3. As an example, aluminum is used for the vapor deposition material 2 in the second example.

A substrate 4 is placed inside the vacuum chamber 1. The substrate 4 is caused to pass above the crucible 3 so as to form thereon a film with the vaporized vapor deposition material 2. Here, Fig. 2 illustrates an example of how the substrate 4 moves during the film formation; solid lines indicate positions of the substrate 4 when the bulk of the vapor deposition material 2 is measured, and a dotted line indicates a position of the substrate 4 when it is caused to pass above the crucible 3 during the film formation.

A sight glass 5 is provided to the vacuum chamber 1 at a position away from a position over the crucible 3. Meanwhile, as an example, quartz glass is used for the sight glass 5 in the second example, but other materials than quartz glass may be used as long as they can transmit laser light therethrough. On a lateral side of the sight glass 5 inside the vacuum chamber 1, there is placed a screen 22 to prevent the vapor deposition material 2 from adhering to the sight glass 5 at the time of the film formation. A laser displacement meter 6 is placed above the sight glass 5 outside the vacuum chamber 1.

A first mirror 20 and a second mirror 21 to reflect laser light are placed inside the vacuum chamber 1. Note that a film of the vapor deposition material 2 comes to be formed also on the first and second mirrors 20 and 21; however, aluminum is used for the vapor deposition material 2 in the second example, which allows the surface of each mirror to remain specular even after formation of the aluminum film thereon. For this reason, the reflection of laser light will not be hindered.

The laser displacement meter 6 measures the distance from the laser displacement meter 6 to the vapor deposition material 2 by: irradiating the first mirror 20 with laser light; irradiating the second mirror 21 with the laser light reflected by the first mirror 20; irradiating an area around the center of the surface of the vapor deposition material 2 in the crucible 3 with the laser light reflected by the second mirror 21; and detecting the laser light reflected by the surface of the vapor deposition material 2 through the same path. Based on the measured distance, the laser displacement meter 6 measures the bulk of the vapor deposition material 2. Then, based on the measured bulk of the vapor deposition material 2, the laser displacement meter 6 calculates the quantity of the remaining vapor deposition material 2 substantially usable for the film formation. In Fig. 2, as an example, a dashed line indicates the optical path of the laser light.

In this way, according to the vacuum vapor deposition apparatus of the second example, it is possible not only to achieve the effect brought about by the vacuum vapor deposition apparatus of the first example, but also to accurately measure the quantity of the remaining vapor deposition material 2 substantially usable for the film formation even during the film formation.

In addition, according to the vacuum vapor deposition apparatus of the second example, the laser displacement meter 6 is placed at a separate position from a position over the crucible 3. This makes it possible to prevent the vapor deposition material 2 from adhering to the sight glass 5.

### {Third Example}

A third example of the vacuum vapor deposition apparatus according to the present invention will be described below.
As shown in Fig. 3, the vacuum vapor deposition apparatus according to the third example has a crucible 3 placed inside a vacuum chamber 1. The crucible 3 is a container for vaporizing a vapor deposition material 2, meaning that the vapor deposition material 2 is vaporized in the crucible 3. As an example, aluminum is used for the vapor deposition material 2 in the third example.

A substrate 4 is placed inside the vacuum chamber 1. The substrate 4 is caused to pass above the crucible 3 so as to form thereon a film with the vaporized vapor deposition material 2. Here, Fig. 3 illustrates an example of how the substrate 4 moves during the film formation; solid lines indicate positions of the substrate 4 when the bulk of the vapor deposition material 2 is measured, and a dotted line indicates a position of the substrate 4 when it is caused to pass above the crucible 3 during the film formation.

A sight glass 5 is placed in a lower portion of the vacuum chamber 1. Meanwhile, as an example, quartz glass is used for the sight glass 5 in the third example, but other materials than quartz glass may be used as long as they can transmit laser light therethrough. A laser displacement meter 6 is placed below the sight glass 5 outside the vacuum chamber 1.

A mirror 30 to reflect laser light is placed inside the vacuum chamber 1. Note that a film of the vapor deposition material 2 comes to be formed also on the mirror 30; however, aluminum is used for the vapor deposition material 2 in the third example, which allows the surface of the mirror to remain specular even after formation of the aluminum film thereon. For this reason, the reflection of laser light by the mirror 30 will not be hindered.

The laser displacement meter 6 measures the distance from the laser displacement meter 6 to the vapor deposition material 2 by: irradiating the mirror 30 with laser light; irradiating an area around the center of the surface of the vapor deposition material 2 in the crucible 3 with the laser light reflected by the mirror 30; and detecting the laser light reflected by the surface of the vapor deposition material 2 through the same path. Based on the measured distance, the laser displacement meter 6 measures the bulk of the vapor deposition material 2. Then, based on the measured bulk of the vapor deposition material 2, the laser displacement meter 6 calculates the quantity of the remaining vapor deposition material 2 substantially usable for the film formation. In Fig. 3, as an example, a dashed line indicates the optical path of the laser light.

In this way, according to the vacuum vapor deposition apparatus of the third example, it is possible not only to achieve the effect brought about by the vacuum vapor deposition apparatus of the first example, but also to accurately measure the quantity of the remaining vapor deposition material 2 substantially usable for the film formation even during the film formation.

In addition, according to the vacuum vapor deposition apparatus of the third example, the laser displacement meter 6 is placed below the vacuum chamber 1. This makes it possible to prevent the vapor deposition material 2 from adhering to the sight glass 5.

### {Fourth Example}

A fourth example of the vacuum vapor deposition apparatus according to the present invention will be described below.
As shown in Fig. 4, the vacuum vapor deposition apparatus according to the fourth example has a crucible 3 placed inside a vacuum chamber 1. The crucible 3 is a container for vaporizing a vapor deposition material 2, meaning that the vapor deposition material 2 is vaporized in the crucible 3. As an example, aluminum is used for the vapor deposition material 2 in the fourth example.

A substrate 4 is placed inside the vacuum chamber 1. The substrate 4 is caused to pass above the crucible 3 so as to form thereon a film with the vaporized vapor deposition material 2. An X-ray source 40 is placed at a lateral outer side of the vacuum chamber 1. The X-ray source 40 irradiates the crucible 3 with an X ray from the lateral side. The X ray having passed through the crucible 3 is detected by an X-ray detector 41 whereby the bulk of the vapor deposition material 2 is measured. Based on the measured bulk of the vapor deposition material 2, the quantity of the remaining vapor deposition material 2 substantially usable for the film formation is calculated. Here, Fig. 4 illustrates an example of how the substrate 4 moves during the film formation, and also the irradiation direction of the X ray by a dashed line.

In this way, according to the vacuum vapor deposition apparatus of the fourth example, use of X ray allows measurement of the bulk of the vapor deposition material 2 even when the substrate 4 is caused to pass above the crucible 3 during the film formation for example. This makes it possible not only to achieve the effect brought about by the vacuum vapor deposition apparatus according to the first example, but also to accurately measure, any time, the quantity of the remaining vapor deposition material 2 substantially usable for the film formation.

### {Industrial Applicability}

The present invention is applicable for example to a vacuum vapor deposition apparatus in which a crucible as a container for vaporizing a vapor deposition material is placed inside a vacuum changer and a film is formed on a substrate by use of the vapor deposition material vaporized in the crucible.

### {Reference Signs List}

1 VACUUM CHAMBER
2 VAPOR DEPOSITION MATERIAL
3 CRUCIBLE
4 SUBSTRATE
5 SIGHT GLASS
6 LASER DISPLACEMENT METER
10SHUTTER
20FIRST MIRROR
21SECOND MIRROR
22 SCREEN
30MIRROR
40X-RAY SOURCE
41X-RAY DETECTOR

## Claims

**1.**
A vacuum vapor deposition apparatus in which a crucible (3) as a container for vaporizing a vapor deposition material (2) is placed in a vacuum chamber (1) and a film is formed on a substrate (4) by use of the vapor deposition material (2) vaporized in the crucible (3), the vacuum vapor deposition apparatus **characterized by** comprising measuring means (6) for measuring a bulk of the vapor deposition material (2) in the crucible (3) from an outside of the vacuum chamber (1).

**2.**
The vacuum vapor deposition apparatus according to claim 1, **characterized in that** the measuring means (6) measures the bulk of the vapor deposition material (2) in the crucible (3) by use of laser light.

**3.**
The vacuum vapor deposition apparatus according to claim 2, **characterized in that** the measuring means (6) is placed over the crucible (3).

**4.**
The vacuum vapor deposition apparatus according to claim 2, **characterized by** further comprising one or more mirrors (20, 21, 30) inside the vacuum chamber (1) to reflect the laser light, the vacuum vapor deposition apparatus **characterized in that**
the measuring means (6) is placed at a position other than a position over the crucible (3).

**5.**
The vacuum vapor deposition apparatus according to claim 1, **characterized in that** the measuring means (6) measures the bulk of the vapor deposition material (2) in the crucible (3) by use of an X ray.
